(19) Europäisches Patentamt
European Patent Office
Office européen des brevets

(11) EP 4 742 301 A1

(12) EUROPEAN PATENT APPLICATION

(43) Date of publication:
13.05.2026 Bulletin 2026/20

(51) International Patent Classification (IPC):
H01L 21/67 (2006.01)

(21) Application number: 24212120.0

(22) Date of filing: 11.11.2024

(52) Cooperative Patent Classification (CPC):
H10P 72/0428; H10P 72/0412; H10P 72/7614;
H10W 72/07118

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ASML Netherlands B.V.
5500 AH Veldhoven (NL)

(72) Inventor: DOLK, Victor, Sebastiaan
5500 AH Veldhoven (NL)

(74) Representative: ASML Netherlands B.V.
Corporate Intellectual Property
P.O. Box 324
5500 AH Veldhoven (NL)

(54) **BONDING APPARATUS**

(57) Disclosed is a bonding apparatus for bonding a first substrate to a second substrate, the bonding apparatus comprising: a first support configured to support the first substrate; a second support configured to support the second substrate, wherein at least one of the first support and the second support comprises a surface to be conditioned, the surface configured to support the substrate; and a surface conditioner comprising at least one conditioning tool configured to contact the surface to be conditioned so as to condition the surface.

## Fig. 8

EP 4 742 301 A1

**Description**

FIELD OF INVENTION

The present invention relates to a bonding apparatus and a method for bonding a first substrate to a second substrate, more particularly a first semiconductor substrate to a second semiconductor substrate.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

Process control methods are used in the manufacture of integrated devices to monitor and control the processes of application of a pattern on a substrate or measurement of such a pattern. Such process control techniques are typically performed to obtain corrections for control of the process. Subsequently, it is sometimes required (for certain devices) to bond substrates together. Bonding processes include die-to-die, die-to-wafer and wafer-to-wafer. Wafer-to-wafer bonding, where whole wafers are permanently bonded together prior to dicing, has the potential of providing a high accuracy and high throughput bonding solution.

When bonding, it is possible for there to be stresses internal to the wafers or dies that are being bonded. Such stresses can cause undesirable misalignment between the dies or wafers that are being bonded together. It is also possible that the wafers or dies may not be completely flat when they are bonded together. This can also use undesirable misalignment between the dies or wafers that are being bonded together. It would be desirable to improve the alignment between the dies or wafers that are being bonded together.

SUMMARY OF THE INVENTION

In a first aspect of the invention, there is provided a bonding apparatus for bonding a first substrate to a second substrate, the bonding apparatus comprising: a first support configured to support the first substrate; a second support configured to support the second substrate, wherein at least one of the first support and the second support comprises a surface to be conditioned, the surface configured to support the substrate; and a surface conditioner comprising at least one conditioning tool configured to contact the surface to be conditioned so as to condition the surface.

In a second aspect of the invention, there is provided a method for bonding a first substrate to a second substrate, the method comprising: supporting a first substrate with a first support; supporting a second substrate with a second support, wherein at least one of the first support and the second support comprises a surface to be conditioned, the surface configured to support the substrate; and contacting the surface to be conditioned with a surface conditioner so as to condition the surface.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example, with reference to the accompanying drawings in which:

Figure 1 depicts a lithographic apparatus together with other apparatuses forming a production facility for semiconductor devices;
Figure 2 is a flow diagram describing a present method of manufacturing integrated devices which utilizes wafer-to-wafer bonding;

Figure 3 schematically depicts the main steps of a method of bonding a first semiconductor substrate to a second semiconductor substrate, in accordance with an embodiment;

Figure 4 schematically depicts the main steps of a variant of the method shown in Figure 3;

Figure 5 schematically depicts a bonding apparatus, for example used in the method shown in Figure 2;

Figure 6 is a graph showing distortion resulting from wafer-to-wafer bonding;

Figure 7 schematically depicts a surface conditioner, for example of the bonding apparatus shown in Figure 5; and

Figure 8 schematically depicts an alternative surface conditioner, for example of the bonding apparatus shown in Figure 5.

DETAILED DESCRIPTION

Before describing embodiments of the invention in detail, it is instructive to present an example environment in which embodiments of the present invention may be implemented.

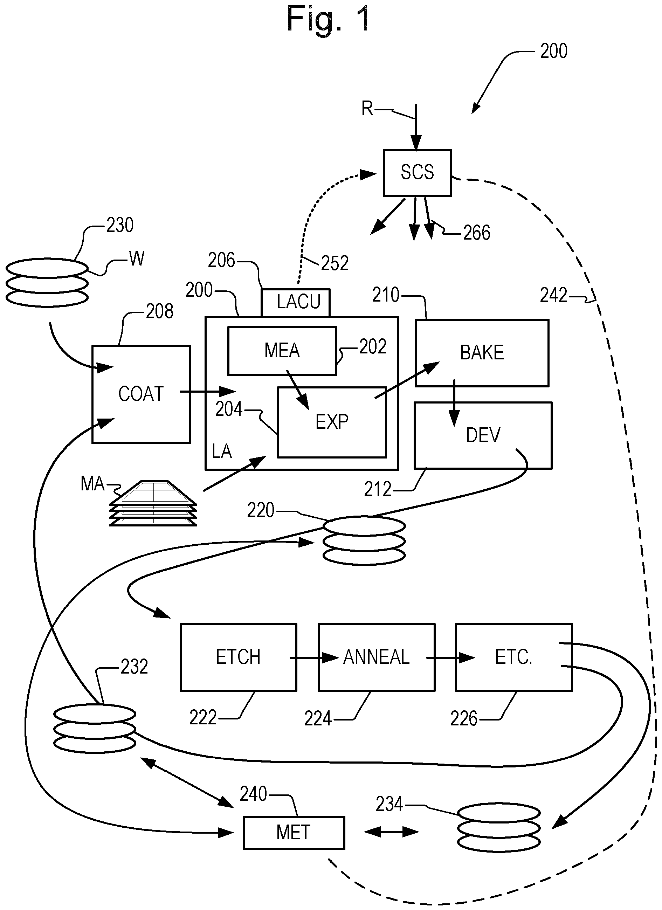

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

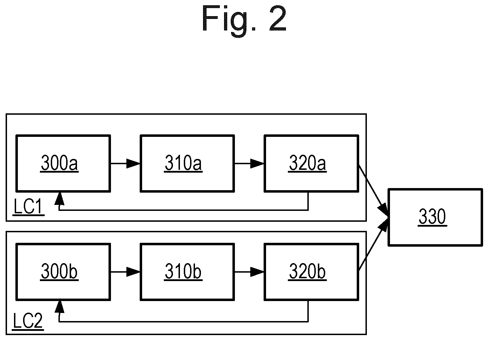

Figure 2 shows a device manufacturing arrangement for making bonded substrates (and therefore ICs based on bonded substrates) comprising a first manufacturing lithocell LC1 and a second manufacturing lithocell LC2. Within each lithocell is a pair of lithographic processing systems 300a, 300b and first metrology systems 310a, 310b. The lithographic processing system 300a, 300b, may comprise a full patterning system. Such a system may comprise, for example, an optical lithographic apparatus or scanner such as described in respect of Figure 1, a track tool, a deposition tool, an etch tool, any other apparatus used in the patterning process, or any combination selected therefrom. The systems may also each comprise a software application 320a, 320b in communication with its respective lithographic processing system 300a, 300b and metrology system 310a, 310b, so that results, designs, data, etc. of the lithographic processing system 300a, 300b and/or the metrology apparatus 310a, 310b may be stored and analyzed by the software application 320a, 320b at the same time or different times.

Once pairs of substrates or wafers are completed from each of lithocell LC 1 and lithocell LC2, they may be bonded within a bonding tool 330 to obtain a bonded wafer. Bonding in this context is wafer-to-wafer bonding where whole wafers are aligned and bonded together such that individual dies on each wafer are aligned. The concept of wafer-to-wafer bonding is known and used in many IC manufacturing processes. The bonding tool 330 may comprise a bonding alignment device for aligning the wafers together for bonding. For example, the bonding tool 330 may perform pre-align using box-in-box marks provided to wafers (e.g., one box on each wafer), with visual inspection of marks used for alignment quality/position control. Another method uses two imaging sensors (e.g., face to face) which are first calibrated together to find their relative positions; each sensor is then used to separately align a respective wafer to be bonded.

Lithocell LC1 and lithocell LC2 may be the same lithocell, different lithocells but comprising one or more shared tools and elements, or be completely different lithocells having completely different sets of apparatuses and tools, possibly even at different sites or fabs. For example, one or more of the tools or apparatuses of the lithographic processing systems 300a and 300b may comprise different tools or the same tools within each respective system. Similarly metrology apparatuses 310 and 310b may be the same apparatus or different apparatuses. The software application 320a, 320b may be comprised within one or both of the respective lithographic processing systems 300a, 300b and/or one or both of the first metrology systems 3 10a, 3 10b, or elsewhere.

Once bonded, the bonded wafer may be subject to further lithographic patterning and processing. As such, alignment will be performed on the bonded wafer; e.g., for aligning the substrate and determining feed-forward corrections based on measured grid deformities. Also post-exposure metrology, such as overlay metrology, may be performed on the bonded wafer after exposure; e.g., to determine feedback corrections for subsequent wafers.

At present, various bonding techniques have been implemented to bond semiconductor substrates (often referred to as wafers). Among existing bonding techniques, fusion bonding and hybrid bonding are widely employed for bonding semiconductor substrates. Fusion bonding enables permanent connection via dielectric layers on each bonding semiconductor substrate and provides a good bonding strength with a high bonding yield. Typically, the fusion bonding process comprises three main steps: 1) wafer surface preparation which may include surface planarization, cleaning and activation; 2) pre-bonding at room temperature which may include aligning the two bonding surfaces; and 3) annealing (or heat treatment) at elevated temperatures (e.g., 200°C to 500°C). In the fusion bonding process, spontaneous adhesion of the two bonding surfaces occurs at room temperature via hydrogen bridge bonds of chemisorbed water molecules which react during the annealing step to form covalent siloxane bonds. Further information about the fusion bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

Hybrid bonding combines fusion bonding and metal diffusion bonding into a single bonding process and enables simultaneous formation of dielectric-to-dielectric and metal-to-metal bonds between the two bonding surfaces. This is achieved by embedding metal (e.g., copper, gold) pads in a dielectric layer on each bonding semiconductor substrate. Similar to the fusion bonding process, the hybrid bonding process also comprises the following three main steps: 1) wafer surface preparation; 2) pre-bonding at room temperature; and 3) annealing (or heat treatment) at elevated temperatures. The surface preparation step of the hybrid bonding process further includes forming metal pads on the surface of each bonding semiconductor substrate which is typically achieved by etching the dielectric layer on the semiconductor substrate (e.g., to create vias to the metal below) and electroplating (or electrochemical deposition (ECD)) at least part of the etched dielectric layer to form metal pads therewithin. In the hybrid bonding process, the dielectric layers of the two bonding substrates are first bonded at low temperatures via hydrogen bridge bonds of chemisorbed water molecules (see fusion bonding above). The subsequent annealing step transfers such hydrogen bridge bonds to covalent siloxane bonds and at the same time enables formation of metal diffusion bonds. Further information about the hybrid bonding technique can be found in the book "Handbook of Wafer Bonding" edited by Peter Ramm, James J.-Q. Lu, and Maaike M. V. Taklo, published by Wiley-VCH, 11 January 2012, ISBN 9783527326464, which is incorporated herein by reference.

In many fusion or hybrid bonding applications, intermediate layers (e.g., silicon dioxide (SiOz), silicon carbon nitride (SiCN), silicon oxynitride (SiON)) are used to enhance bonding strength. However, even with intermediate layers, existing bonding techniques (e.g., fusion bonding) can still introduce high-order wafer distortions and significant variations in wafer-to-wafer distortions, which negatively impact the overlay performance of the bonded wafer when further lithographic patterning (e.g., patterning interconnects) is performed on one or both of the backsides of the bonded wafer. This is mainly due to the fact that those intermediate layers are rigid layers and thus cannot absorb the stress introduced into the bonded wafer during the bonding process. The term "backside" refers to the unbonded side of one of the two bonding wafers. Thus, a bonded wafer comprises two backsides belonging respectively to the two bonding wafers. The order and amplitude of such bonding-induced wafer distortions are strongly affected by the coating deposition technology that has been used to deposit the intermediate layers to the wafers. This is because different coating deposition technologies may require for example different operating temperatures, different pressures, different coating materials, and/or different coating times, and may result in different coating uniformities, all of which can cause wafer distortions. Therefore, it is the object of the present disclosure to provide a solution to the problems associated with the prior art bonding techniques.

One aspect of the present disclosure provides a method of bonding a first semiconductor substrate to a second semiconductor substrate, the method comprising: providing a stress-relieving coating to at least one of the first semiconductor substrate and the second semiconductor substrate; and bonding the first semiconductor substrate to the second semiconductor substrate to form a bonded substrate; wherein the stress-relieving coating is configured to enhance a bonding strength between the first semiconductor substrate and the second semiconductor substrate and reduce an amount of bonding-induced stress in the bonded substrate. Advantageously, the proposed method is capable of minimizing or mitigating the negative impact of wafer distortions resulting from e.g., unoptimized bonding parameters and/or process variabilities to the overlay performance of the bonded wafer during subsequent wafer-backside patterning and processing. This is achieved by using at least one stress-relieving coating to relieve or minimize the bonding-induced stress inside the bonded substrate.

The proposed method may be applicable to various semiconductor substrate bonding techniques. Preferably, the proposed method may be used for bonding two semiconductor substrates via fusion bonding or hybrid bonding (as described above).

The amount of bonding-induced stress in the bonded substrate may include an amount of bonding-induced stress within one or more of: the stress-relieving coating deposited to at least one of the first semiconductor substrate and the second semiconductor substrate, the first semiconductor substrate, and the second semiconductor substrate.

In an embodiment, the step of providing a stress-relieving coating to at least one of the first semiconductor substrate and the second semiconductor substrate may comprise depositing a stress-relieving coating to at least one of the first semiconductor substrate and the second semiconductor substrate. The one or two stress-relieving coatings (if deposited to both semiconductor substrates) may each have the following material properties at room temperature:

$$\text{Young's modulus E} \ < \ 5 \times 10^{-2} \text{ GigaPascal (GPa)}$$

$$\text{Complex modulus G} \ < \ 5 \times 10^{-3} \text{ GigaPascal (GPa)}$$

$$\text{Viscosity } 10^{3} \ < \ \mu \ < \ 10^{5} \text{ Pascal-second (Pa·s)}$$

Each stress-relieving coating may act as a 'soft' intermediate layer between the first semiconductor substrate and the second semiconductor substrate. As mentioned above, in the existing fusion bonding or hybrid bonding method, an intermediate layer (e.g., $SiO_2$ or SiCN) is deposited to one or both of the two bonding semiconductor substrates to enhance the bonding strength between the two substrates. However, existing intermediate layers are typically deposited to semiconductor substrates by chemical vapor deposition (CVD) or physical vapor deposition (PVD). Thus, those intermediate layers are rigid layers and cannot function to absorb or relieve the bonding-induced stress in the bonded substrate. Further information about chemical vapor deposition and physical vapor deposition can be found in the book "Handbook of Thin Film Deposition Processes and Techniques" edited by Krishna Seshan, published by Noyes Publications, 2002, ISBN: 0-8155-1442-5, which is incorporated herein by reference.

In contrast, the 'soft' intermediate layers used in the proposed bonding method not only enhance the bonding strength between the two semiconductor substrates but also allow to relieve or minimize the bonding-induced stress in the bonded substrate.

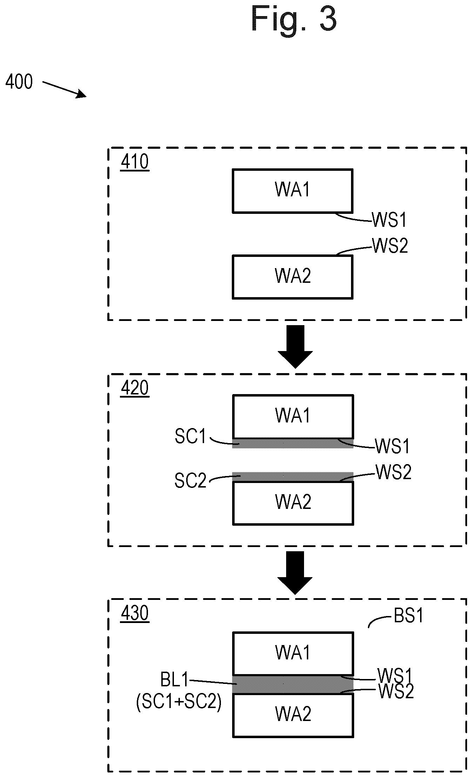

Figure 3 schematically depicts the proposed bonding method 400 in accordance with an embodiment. In this embodiment, the method 400 may comprise the following three main steps 410-430.

In step 410, a first wafer WA1 and a second wafer WA2 may be provided for bonding.

In an embodiment, the method 400 may comprise preparing a first surface WS 1 of the first semiconductor substrate WA1 and a second surface WS2 of the second semiconductor substrate WA2. How to prepare the first surface WS 1 and the second surface WS2 may depend on the coating deposition technique used for coating one or both of the semiconductor substrates WA1 and WA2, and/or depend on the bonding technique (e.g., fusion bonding or hybrid bonding) used for bonding the semiconductor substrates WA1 and WA2 (see below). This is because different coating deposition techniques or different bonding techniques may have different requirements for surface conditions of semiconductor substrates WA1 and WA2.

In step 420, a stress-relieving coating may be provided to at least one of the first bonding surface WS1 and the second bonding surface WS2. The one or two stress-relieving coatings may each be deposited to a respective semiconductor substrate via a spin-on deposition process and may each have the following material properties at room temperature:

$$\text{Young's modulus E} < 5 \times 10^{-2} \text{ GPa}$$

$$\text{Complex modulus G} < 5 \times 10^{-3} \text{ GPa}$$

$$\text{Viscosity } 10^3 < \mu < 10^5 \text{ Pa·s}$$

Further information about spin-on deposition can be found in the book "Handbook of Thin Film Deposition Processes and Techniques" edited by Krishna Seshan, published by Noyes Publications, 2002, ISBN: 0-8155-1442-5, which is incorporated herein by reference.

In the embodiment shown in Figure 3, a first stress-relieving coating SC1 may be deposited to the first surface WS1 of the first semiconductor substrate WA1 and a second stress-relieving coating SC2 may be deposited to the second surface WS2 of the second semiconductor substrate WA2.

The stress-relieving coating SC1 or SC2 may comprise a dielectric layer. The dielectric layer may be for example a layer of SiOz or SiCN. Such a stress-relieving coating may be suitable for fusion bonding.

In an alternative embodiment, the stress-relieving coating SC1 or SC2 may comprise a dielectric layer and a plurality of conductive (e.g., metal such as copper, gold) pads or interconnects embedded therewithin. Such a stress-relieving coating may be suitable for hybrid bonding. In this alternative embodiment, the step 420 may further comprise etching the deposited dielectric layer and electroplating at least part of the etched dielectric layer to form the plurality of conductive (e.g., metal such as copper, gold) pads on the at least one of the first bonding surface WS1 and the second bonding surface WS2.

While a thicker stress-relieving coating SC 1 or SC2 may be able to reduce or absorb a greater amount of the stress in the bonded substrate BS1, it is preferable to keep a balance between the thickness and the rigidity of the stress-relieving coating SC1 or SC2. This is because if the stress-relieving coating SC1 or SC2 becomes too thick, the resultant bonded substrate BS1 may not provide sufficient rigidity that is required for subsequent lithographic patterning and/or processing. Consequently, the overlay performance of the bonded substrate BS1 may be negatively impacted. Preferably, the stress-relieving coating SC1 or SC2 may have a thickness for example between 1 nanometer to 1000 nanometers, between 1 nanometer to 100 nanometers, or between 10 nanometers to 50 nanometers.

In step 430, the first semiconductor substrate WA1 and the second semiconductor substrate WA2 may be bonded to form a bonded substrate BS1. The two semiconductor substrates WA1 and WA2 may be bonded by fusion bonding or hybrid bonding.

With continued reference to Figure 3, the first semiconductor substrate WA1 and the second semiconductor substrate WA2 may be bonded by joining a first external surface (not shown) of the first stress-relieving coating SC1 with a second external surface (not shown) of the second stress-relieving coating SC2 to obtain the bonded substrate BS1. The first external surface of the first stress-relieving coating SC1 and the second external surface of the second stress-relieving coating SC2 may be joined together by fusion bonding or hybrid bonding. After being bonded together, the first stress-relieving coating SC1 and the second stress-relieving coating SC2 may form a bonded interface layer BL1 between the first semiconductor substrate WA1 and the second semiconductor substrate WA2.

In an alternative embodiment, a stress-relieving coating may be deposited to the first surface WS1 of the first semiconductor substrate WA1 and no stress-relieving coating may be deposited the second surface WS2 of the second semiconductor substrate WA2. In such a case, the first semiconductor substrate WA1 and the second semiconductor substrate WA2 may be bonded by joining an external surface of the stress-relieving coating deposited to the first surface WS1 of the first semiconductor substrate WA1 with the second surface WS2 of the second semiconductor substrate WA2 to obtain the bonded substrate BS1. The single stress-relieving coating may form a bonded interface layer between the first semiconductor substrate WA1 and the second semiconductor substrate WA2.

Optionally, after the bonding step 430, the method 400 may further comprise stiffening the bonded layer BL1 by subjecting the bonded substrate BS1 to a heat treatment process. This optional stiffening step may improve the rigidity of the bonded substrate BS1 which may be required for subsequent lithographic patterning and/or processing on the backsides of the bonded substrate BS1.

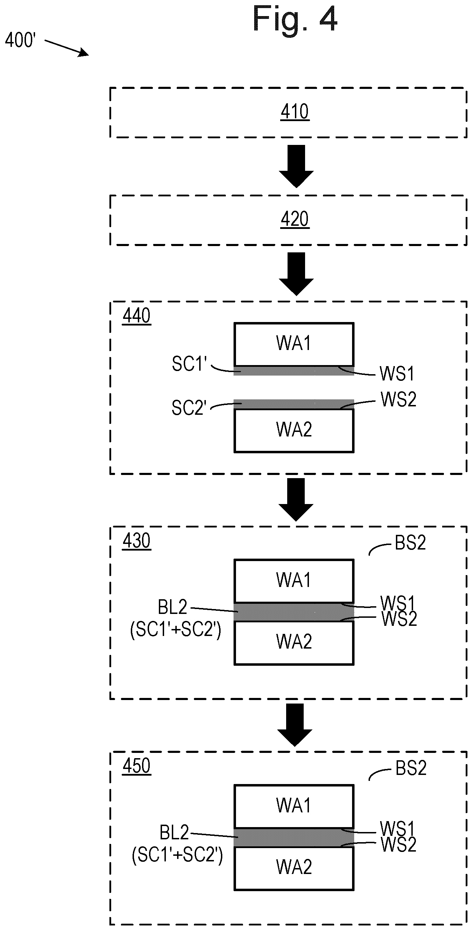

Figure 4 schematically depicts the main steps of a variant 400' of the method 400 shown in Figure 3. In addition to the steps 410-430 of method 400, the method 400' may further comprise steps 440 and 450, which may be performed before and after the bonding step 430, respectively.

In step 440, after the 'soft' stress-relieving coating has been deposited to at least one of the first semiconductor substrate WA1 and the second semiconductor substrate WA2, such a 'soft' coating may then be stiffened.

In the embodiment shown in Figure 4, after being deposited to the first surface WS1 of the first semiconductor substrate WA1 and the second surface WS2 of the second semiconductor substrate WA2, the first stress-relieving coating SC1 and the second stress-relieving coating SC2 may be subject to a heat treatment process (e.g., baking the stress-relieving coatings at a temperature of between 180°C and 300 °C) such that both stress-relieving coatings SC1 and SC2 may be stiffened.

Subsequently, in step 430, the first semiconductor substrate WA1 and the second semiconductor substrate WA2 may be bonded by joining a first external surface (not shown) of the first stiffened stress-relieving coating SC1' with a second external surface (not shown) of the second stress-relieving coating SC2' to obtain the bonded substrate BS2. After being bonded together, the first stiffened stress-relieving coating SC1' and the second stiffened stress-relieving coating SC2' may form a bonded interface layer BL2 between the first semiconductor substrate WA1 and the second semiconductor substrate WA2.

The stiffened coatings SC1' and SC2' may be preferrable for some applications but they may not reduce or minimize the bonding-induced stress in the bonded substrate BS2 as effectively as the 'soft' stress-relieving coatings SC1, SC2 may do. Thus, in step 450, the bonded substrate BS2 may be subject to another heat treatment process (e.g., baking the stress-relieving coatings at a temperature of above 800 °C) after the bonding step 430 which may soften the bonded layer BL2 between the first semiconductor substrate WA1 and the second semiconductor substrate WA2 such that the bonding-induced stress in the bonded substrate BS2 is reduced or minimized.

After the bonding induced stress is reduced or minimized in step 450, the method 400' may further comprise cooling the bonded substrate BS 1 to room temperature such that the bonded layer BL2 is stiffened. The stiffening of the bonded layer BL2 may improve the rigidity of the bonded substrate BS2 which may be required for subsequent lithographic patterning and/or processing on the backsides of the bonded substrate BS2.

While the foregoing embodiments rely on using at least one 'soft' stress-relieving coating to reduce or minimize the bonding-induced stress in the bonded substrate, it is also possible to achieve the same or similar technical effect by using at least one patterned coating. For example, in an embodiment, a coating may first be deposited to at least one of the first semiconductor substrate and the second semiconductor substrate. Subsequently, the at least one coating may be patterned in such a manner that the bonding-induced stress in the bonded substrate is reduced or minimized. For example, the coating, prior to the patterning, may comprise a 'stiff' coating, e.g., having the following material properties at room temperature:

$$\text{Young's modulus E} \> 5 \times 10^{-2} \text{ GPa}$$

$$\text{Complex modulus G} \> 5 \times 10^{-3} \text{ GPa}$$

$$\text{Viscosity } \mu \> 10^{5} \text{ Pa·s}$$

Therefore, each patterned (e.g., 'stiff') coating may perform the same or similar function as a 'soft' stress-relieving coating, i.e. reducing or minimizing the stress in the bonded substrate (as described above).

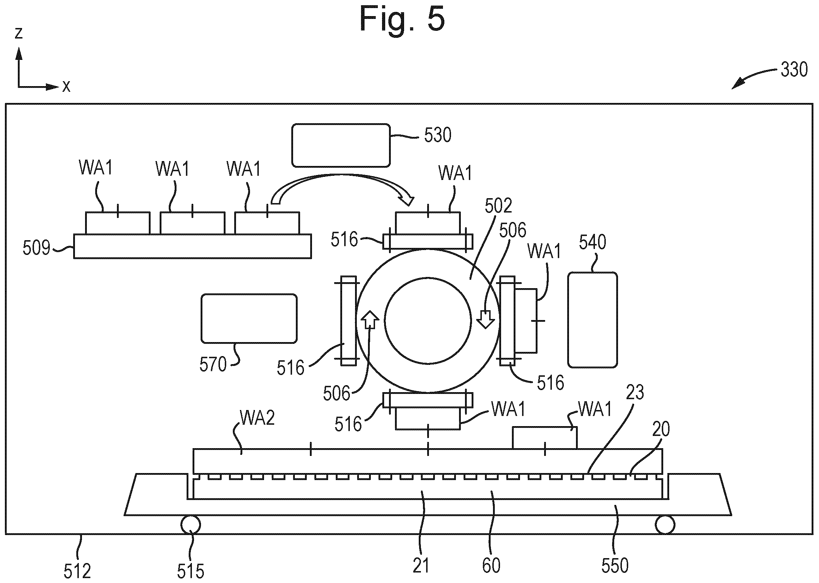

Figure 5 is a schematic diagram illustrating a bonding apparatus 330. The bonding apparatus 330 is shown in Figure 5 performing die-to-wafer bonding. In an embodiment the bonding apparatus 330 is for die-to-die bonding or wafer-to-wafer bonding.

Figure 5 is a cross-sectional view of placement of donor die, which may be referred to as a first wafer WA1 using a first support 502. The first support 502 is substantially circular in the x-z plane, with a longitudinal axis along the y-direction (e.g., the first support 502 is substantially cylindrical in three dimensions). The first support 502 may instead have a different cross-sectional shape, such as square, hexagonal, etc. The first support 502 may have a symmetrical (e.g., as shown) cross-section with one or more axis of symmetry, or asymmetrical cross-sectional area (for example, an irregular polygon).

The first support 502 has die acceptors 516. The placement of the die acceptors 516 may be symmetrical or asymmetrical around the cross-sectional area of the first support 502. The first support 502 may have a substantially symmetrical cross section but have asymmetric placement of recesses. For example, the first support 502 may have a cross-section that is a regular hexagon but have recesses placed asymmetrically along longitudinal faces. The die acceptors 516 are capable of accepting donor dies, such as the first wafer WA1.

The first support 502 may be controllably moved in a direction 506 about the longitudinal axis. The first support 502 may instead be rotated in an opposite direction or any appropriate direction, translated along the x, y, or z direction or any combination thereof. The first support 502 may be operated in both rotational and a translational modes, including sequentially or at the same time. For example, the first support 502 may move in the negative x-direction towards a second support 60 while also rotating about the longitudinal axis. The first support 502 may move continuously or intermittently. For example, the first support 502 may rotate in the direction 506 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the first support 502 is substantially zero), but the positions may instead correspond to continuous (or quasi-continuous movement) or operations may occur while the first support 502 is moving in one or more directions (e.g., rotationally, translationally, etc.).

A first wafer WA1 may be placed on the die acceptor 516 by a pick and place element 530. The pick and place element 530 may place the first wafer WA1 on the first support 502 on the die acceptor 516 based on alignment information, based on positional information of the support first support 502, etc. The pick and place element 530 may place the donor die 210A on the support structure at a given position relative to the die acceptor 516. For example, the pick and place element 530 may center the first wafer WA1 relative to the die acceptor 516. The pick and place element 530 may have intrinsic error or inaccuracy.

The position (e.g., location) of the first wafer WA1 may be measured by a location measurement element 540. The location measurement element 540 may measure an actual position of the first wafer WA1, in relative (such as relative to the die acceptor 516) or absolute terms (such as in distances from an origin point on the support first support 502, on the location measurement element 540, etc.).

Once the position of the first wafer WA1 is measured, the first support 502 may move (e.g., in the direction 506), so that the first wafer WA1 occupies the position of the first wafer WA1 is ready to be placed on a corresponding target, for example, a second wafer WA2. The second wafer WA2 may comprise one or more target dies which may be sequentially contacted by a donor die during various movements of the support first support 502.

The second wafer WA2 is supported by the support structure 250. The donor die 210C may be placed on the second wafer WA2 by motion of the support first support 502 towards the second wafer WA2. Alternatively or additionally, the second support 60 may also be on an actuatable stage 550 operable to bring the first wafer WA1 and the second wafer WA2 into contact. The bonding apparatus 330 may comprise a frame 512. The actuatable stage 550 may be mounted to the frame 512 by a bearing 515.

Once the first wafer WA1 is placed on the second wafer WA2, the first support 502 and the second support 60 may operate (individually or in concert) to place additional first wafers WA1 on the second wafer WA2.

As shown in Figure 5, in an embodiment the second wafer WA2 is supported by a second support 60. In an embodiment the actuatable stage 550 is configured to move the second support 60 and the second wafer WA2 at high accuracy. In an embodiment, a controller is configured to control the first support 502 and the second support 60 so as to accurately place the first wafer WA1 from the donor substrate 509 to the second wafer WA2.

As shown in Figure 5, in an embodiment the bonding apparatus 330 comprises a surface conditioner 570.

The first support 502 may comprise a surface configured to support the substrate. For example, as shown in Figure 5 the first support 502 may comprise a plurality of die acceptors 516. Each die acceptor 516 may comprise a surface configured to support a first wafer WA1. As shown in Figure 5, in an embodiment the second support 60 comprises a surface configured to support the second wafer WA2.

In an embodiment, the surface conditioner 570 is configured to condition the surface of the first support 502, for example a supporting surface of a die acceptor 516. Additionally or alternatively, in an embodiment the surface condition 570 is configured to condition the surface of the second support 60 that is configured to support the second wafer WA2.

By conditioning the surface, the condition of the surface may be improved. For example, during use of the bonding apparatus 330, contaminant particles may contaminate the supporting surface. Conditioning the surface may comprise removing such contaminant particles from the surface. By removing contaminant particles, the possibility of such contaminant particles undesirably causing misalignment between the first wafer WA1 and the second wafer WA2 during bonding may be reduced.

In an embodiment, conditioning the surface comprises roughening the surface. By roughening the surface, the possibility of the first wafer WA 1 or the second wafer WA2 undesirably sticking to the supporting surface may be reduced. By roughening the surface, the amount of the surface that actually comes into contact with the first wafer WA1 or the second wafer WA2 may be reduced. By reducing the amount of contact, the possibility of undesirable sticking when attempting to remove the first wafer WA1 or the second wafer WA2 from the supporting surface may be reduced.

In an embodiment, conditioning the surface comprises flattening the surface. In particular, during use of the bonding apparatus 330, the flatness of the supporting surface may reduce due to wear of the surface. By flattening the surface, the flatness of the surface may be restored. By flattening the surface, the possibility of undesirable undulations in the surface causing misalignment between the first wafer WA 1 and the second wafer WA2 may be reduced.

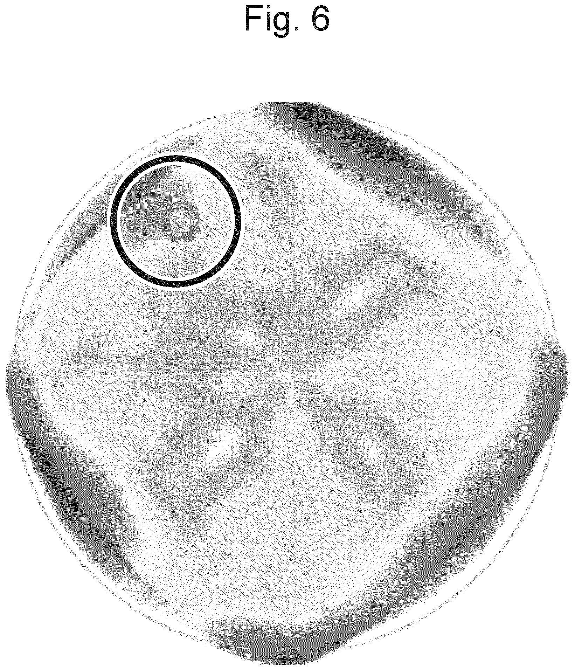

Figure 6 is a graph showing the measured distortion resulting from wafer-to-wafer bonding. The distortion is indicative of misalignment between the first wafer WA 1 and the second wafer WA2. The spot at the top left which is highlighted by a circle shows distortion resulting from a contaminant particle on the supporting surface of one of the supports. As shown in Figure 6, the presence of a contaminant particle can undesirably increase distortion, which can make the quality of the bonding worse. By conditioning the supporting surface, such distortion may be reduced.

An embodiment of the invention is expected to reduce the impact of contamination spots on bonding. An embodiment of the invention is expected to reduce internal stresses (e.g. in-plane stresses) in a substrate (e.g. the first wafer WA1 or the second wafer WA2) after loading it on the first support 502 or the second support 60. An embodiment of the invention is expected to reduce bonding overlay errors as a result of such internal stresses.

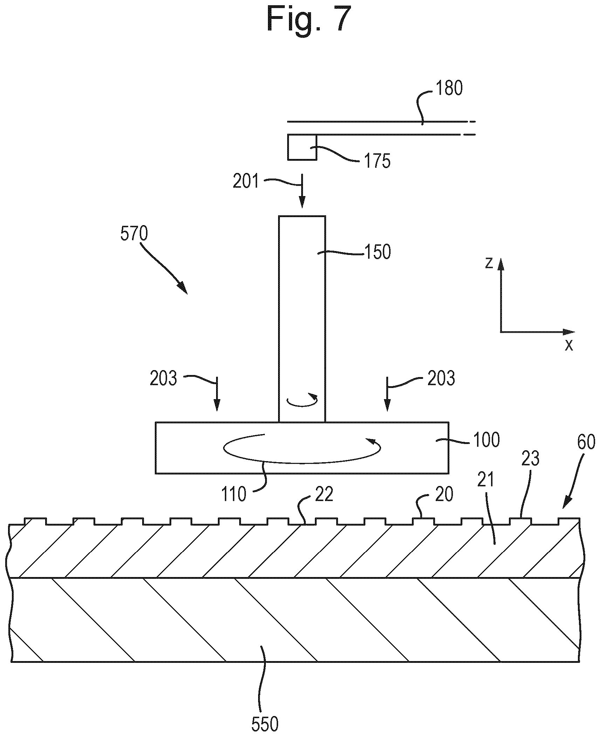

Figure 7 schematically depicts a surface conditioner 570. The surface condition 570 may be comprised in the bonding apparatus 330 shown in Figure 5, for example. The surface conditioner 570 is configured to condition the supporting surface of at least one of the first support 502 and the second support 60.

As shown in Figure 7, in an embodiment the surface conditioner 570 comprises at least one conditioning tool 100. The conditioning tool 100 is configured to contact the surface to be conditioned so as to condition the surface.

For example, in the arrangement shown in Figure 7, the surface conditioner 570 is arranged to condition the surface of the second support 60. As shown in Figure 7, in an embodiment the second support 60 comprises a plurality of burls 20. The burls 20 have distal ends 23 comprising the surface to be conditioned. That is, the second wafer WA 1 is supported by the distal ends 23 of the burls 20 of the second support 60. The distal ends 23 may be arranged in a plane, which may be referred to as a support plane. As shown in Figure 7, in an embodiment the burls 20 protrude from a base surface 22 of a main body 21 of the second support 60. The second support 60 may be supported by the actuatable stage 550.

The surface conditioner 570 may be configured to condition the burls 20 by contacting the distal ends 23 of the burls 20. However, it is not essential for the second support 60 to comprise burls 20. It is not essential for the surface to be conditioned to be the distal ends 23 of such burls 20. In an alternative arrangement, the second support 60 may be configured to have a supporting surface that is substantially flat (i.e. without burls). The surface conditioner 570 may be configured to condition the flat supporting surface of the second support 60.

Similarly, in an embodiment the first support 502 comprises a plurality of burls having distal ends arranged in a support plane for supporting the first wafer WA1. For example, each of the die acceptors 516 may comprise burls for supporting the first wafer WA1 at their distal ends. Alternatively, the first support 502 may be configured to support the first wafer WA1 at a flat supporting surface of the first support 502.

In an embodiment the at least one conditioning tool 100 comprises a cleaning tool configured to remove contaminant matter from the surface. For example, in the arrangement shown in Figure 7, the cleaning tool 100 may be configured to remove contaminant matter from the distal ends 23 of the burls 20. The contaminant matter may be removed from the second support 600. Alternatively, the contaminant matter may be moved from the distal ends 23 to another surface of the second support 60 (e.g. the base surface 22) where the contaminant matter is less likely to disrupt the bonding process.

In an embodiment the surface conditioner 570 comprises a tool actuator configured to actuate the at least one conditioning tool 100 to move parallel to the surface to be conditioned so as to condition the surface. For example, as shown in Figure 7, in an embodiment the at least one conditioning tool 100 is arranged for rotation around the Z axis as illustrated by arrow 110. This may be effected by rotation of a shaft 150. Matter is removed due to the movement of the cleaning tool 100 over the distal ends 23 of the burls 20. The tool actuator may be configured to rotate the at least one conditioning tool 100.

In an embodiment, during use of the surface conditioner 570, the surface to be conditioned and the at least one conditioning tool 100 are moved translationally relative to each other. This may be effected either by movement of the surface conditioner 570 or by movement of the surface to be conditioned. For example, as shown in Figure 7, in an embodiment the bonding apparatus 330 comprises an actuatable stage 550. The actuatable stage 550 may be configured to move the surface to be conditioned relative to the surface conditioner 570 so as to control which part of the surface is conditioned. Relative translational movement in the X and Y directions means that the whole of the surface to be conditioned can be moved under the at least one conditioning tool 100 such that substantially all of the surface can be conditioned (e.g. such that all of the burls 20 can be cleaned).

In an embodiment the bonding apparatus 330 comprises a controller configured to control the bonding apparatus 330 so as to condition the surface with the surface conditioner 570. The controller may be considered to be part of the surface conditioner 570. Alternatively, the controller may be considered to be a separate component from the surface conditioner 570 but comprised in the bonding apparatus 330. The controller may be configured to control one or more other components of the bonding apparatus 330.

In an embodiment, during use of the surface conditioner 570, the surface to be conditioned and the at least one conditioning tool 100 are pressed against each other with a force. As shown in Figure 7, in an embodiment the surface conditioner 570 comprises a force control element 175. The force control element 175 is configured to apply a force in the Z direction between the at least one conditioning tool 100 and a reference portion 180 of the bonding apparatus 330. The reference portion 180 is fixed in the Z direction relative to the bonding apparatus 330 during use of the surface conditioner 570. The reference portion 180 may be a frame or other component, for example part of the frame 512 shown in Figure 5. The force control element 170 is configured to apply a force between the reference portion 180 and the at least one conditioning tool 100 to move the conditioning tool 100 closer to or further away from the reference portion 180 in the Z direction. In an embodiment the conditioning tool 100 is selectively retractable.

In an embodiment the force control element 175 is configured to apply the force along the axis of the shaft 150. The shaft 150 is attached to the conditioning tool 100 at the mass centre of the conditioning tool 100. In Figure 7, the force of the force control element 175 along the axis of the shaft 150 is illustrated by arrow 201.

Alternatively or additionally, the force control element 175 is configured to apply the force off axis, for example on the top of the conditioning tool 100 as illustrated by arrows 203. One or more contact members may be present for applying the forces 203. The forces 203 may be aligned so as to reduce or eliminate any unwanted torque momentum on the conditioning tool 100.

In an embodiment the controller is configured to control the force with which the surface to be conditioned and the conditioning tool 100 are pressed against each other. In an embodiment the surface conditioner 570 comprises an actuator such as the force control element 175 for effecting the force. The force control element 175 may comprise an electromagnetic actuator.

Alternatively, the force may be controlled passively by the mass of the surface conditioner 570. By providing a passive force, the variation over time of the force on the surface to be conditioned may be reduced. This may help to improve control of the conditioning of the surface.

In an embodiment, the force control element 175 applies a biasing force on the conditioning tool 100. The magnitude of the biasing force may vary as a function of the distance between the conditioning tool 100 and the reference portion 180. In an embodiment the force control element 175 comprises a spring. By selecting the stiffness of the spring, at a certain amount of compression the required down force on the conditioning tool 100 ensures that the correct force between the conditioning tool 100 and the second support 60 is applied. The compression length of the force control element 175 depends upon the decision in the Z direction of the second support 60 relative to the reference portion 180.

In an embodiment the surface conditioner 570 comprises a passive forcer such as a spring configured to push the conditioning tool 100 onto the surface to be conditioned. The level of force applied by the spring may be controlled, for example by actuating the conditioning tool 100 in the Z direction and/or by actuating the surface to be conditioned (e.g. by the actuatable stage 550) in the Z direction.

In an embodiment the actuatable stage 550 is used to control the height of the second support 60. The actuatable stage 550 may be used to control the force applied by the force control element 175 between the reference portion 180 and the conditioning tool 100. The actuatable stage 550 may be configured to move the surface to be conditioned toward or away from the reference portion 180. Thereby the magnitude of the biasing force applied by the force control element 175 between the reference portion 180 and the conditioning tool may be lowered or raised so as to control the force on the surface, for example so as to maintain the force to be substantially constant.

Additionally or alternatively, the surface conditioner 570 may comprise a chain of masses. In an embodiment the surface conditioner 570 is configured such that the number of masses that apply a force onto the surface to be conditioned is determined by the distance between the surface and the conditioning tool 100.

In an embodiment the actuatable stage 550 is configured to move the second support 60 in the X and Y directions during a conditioning procedure whilst the conditioning tool 100 is stationary in the X and Y directions.

In an embodiment one or more actuators move the second support 60 and/or the conditioning tool 100 in the Z direction relative to each other so as to apply a variable force in the Z direction between the conditioning tool 100 and the second support 60. The controller may be configured to control the magnitude of the variable force applied by the at least one actuator dependent on a position in the X and Y directions of the conditioning tool 100 relative to the second support 60.

In an embodiment the controller is configured to control a speed of relative movement between the surface and the conditioning tool 100. For example, the controller may be configured to control the speed of translational movement between the surface and the conditioning tool 100. By controlling the speed of translational movement, the time for which each part of the surface (e.g. each burl 20) is actively conditioned by the surface conditioner 570 may be controlled.

In an embodiment the speed is a rotational speed. The controller may be configured to control the speed of rotation between the surface and the conditioning tool 100. By controlling the rotational speed, the strength of the conditioning may be controlled.

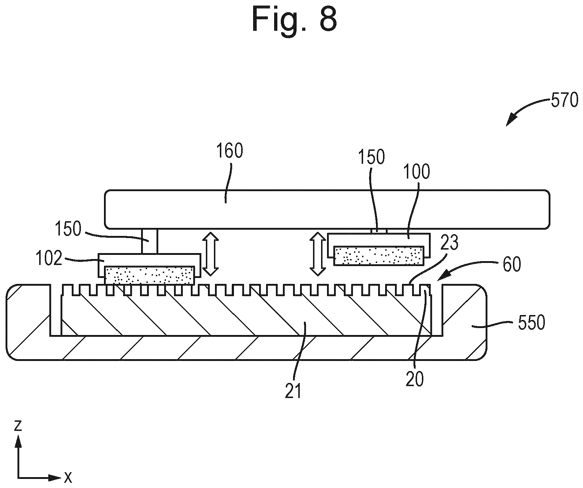

Figure 8 schematically depicts a surface conditioner 570, for example of the bonding apparatus 330 shown in Figure 5. The surface conditioner 570 may have features as described with reference to Figure 7.

As shown in Figure 8, in an embodiment the surface conditioner 570 comprises a plurality of conditioning tools 100, 102. The different conditioning tools may have different functions. For example, as mentioned above in an embodiment at least one conditioning tool is a cleaning tool 100 configured to remove contaminant matter from the surface to be conditioned. In an embodiment the at least one conditioning tool comprises a roughening tool 102. The roughening tool 102 is configured to roughen the surface. For example, the roughening tool 102 may be configured to roughen the surface so as to reduce the possibility of the substrate (e.g. the second wafer WA2) undesirably sticking to the surface of the second support 60.

In an embodiment the surface conditioner 570 is configured such that each conditioning tool 100, 102 is selectively applicable to the surface to be conditioned. For example, in an embodiment each conditioning tool is selectively retractable. For example, Figure 8 shows the cleaning tool 100 in a retracted position while the roughening tool 102 is in an extended position.

As shown in Figure 8, in an embodiment each conditioning tool 100, 102 is connected to a respective shaft 150. As shown in Figure 8, in an embodiment the surface conditioner 570 comprises a main body 160. In an embodiment the main body 160 is connected to the conditioning tools 101, 102 via their respective shafts 150.

Although not shown in the Figures, in an embodiment the surface conditioner 570 may comprise more than two conditioning tools.

In an embodiment the at least one conditioning tool comprises a flattening tool. The flattening tool is configured to flatten the surface. For example, the flattening tool may be configured to restore the flatness of the surface after use of the bonding apparatus 330.

In an embodiment the controller is configured to selectively control which of the conditioning tools 100, 102 is to condition the surface to be conditioned.

In an embodiment the controller is configured to control the timing at which the surface is conditioned. For example, the controller may be configured to control the bonding apparatus 330 so as to condition the surface with the surface conditioner 570 based on a predetermined schedule. That is, the surface conditioner 570 may be used regularly to condition the surface. An embodiment of the invention is expected to improve the condition of the supporting surfaces for supporting the first wafer WA1 and the second wafer WA2 during a bonding process. An embodiment of the invention is expected to improve the condition of the supporting surfaces after, i.e. following use of the bonding apparatus 330.

In an embodiment the controller is configured to control the bonding apparatus 330 so as to condition the surface with the surface conditioner 570 based on a measurement signal indicative of a deteriorated condition of the surface. The surface conditioner 570 may be used to recondition the surface only when it is determined that reconditioning is required. This may help to keep the surface in a good condition, without performing unnecessary reconditioning of the surface. This may save time and power.

For example, in an embodiment the bonding apparatus 330 comprises a deterioration sensor. The deterioration sensor is configured to output a measurement signal indicative of the deteriorated condition of the surface. In an embodiment the deterioration sensor is configured to output the measurement signal to the controller. The controller is configured to control the surface conditioner 570 to recondition the surface upon receipt of a measurement signal indicating that the surface of the first support 502 and/or the second support 60 has deteriorated, for example below a threshold level. For example, as mentioned above a metrology apparatus 240 may be configured to measure properties of substrates. In an embodiment such a metrology apparatus 240 is configured to measure flatness of the first wafer WA1 or the second wafer WA2. Additionally or alternatively, the location measurement element 540 of the bonding apparatus 330 may be configured to measure flatness of the first wafer WA1. The metrology apparatus 240 and/or the location measurement element 540 may function as the deterioration sensor.

Additionally or alternatively, as mentioned above, alignment may be performed on the bonded wafer, e.g. for aligning the wafers and determining feed-forward corrections based on measured grid deformities. In an embodiment the measurement of the grid deformities comprises the measurement signal indicative of the deteriorated condition of the surface. For example, when it is determined that the grid deformities are above a threshold level, then a signal may be sent to the controller to initiate conditioning of the surface by the surface conditioner 570.

In an embodiment the bonding apparatus 330 comprises a plurality of surface conditioners 570. For example, a plurality of surface conditioners 570 may be provided for cleaning supporting surfaces of the first support 502 and the second support 60, respectively.

Further embodiments are disclosed in the list of numbered clauses below:

1. A bonding apparatus for bonding a first substrate to a second substrate, the bonding apparatus comprising: a first support configured to support the first substrate; a second support configured to support the second substrate, wherein at least one of the first support and the second support comprises a surface to be conditioned, the surface configured to support the substrate; and a surface conditioner comprising at least one conditioning tool configured to contact the surface to be conditioned so as to condition the surface.

2. The bonding apparatus of clause 1, wherein the at least one conditioning tool comprises:

a cleaning tool configured to remove contaminant matter from the surface.

3. The bonding apparatus of clause 1 or 2, wherein the at least one conditioning tool comprises:

a roughening tool configured to roughen the surface.

4. The bonding apparatus of any preceding clause, wherein the at least one conditioning tool comprises: a flattening tool configured to flatten the surface.

5. The bonding apparatus of any preceding clause, wherein each conditioning tool is selectively retractable.

6. The bonding apparatus of any preceding clause, wherein the surface conditioner comprises:

a tool actuator configured to actuate the at least one conditioning tool to move parallel to the surface so as to condition the surface.

7. The bonding apparatus of clause 6, wherein the tool actuator is configured to rotate the at least one conditioning tool.

8. The bonding apparatus of any preceding clause, wherein at least one of the first support and the second support comprises a plurality of burls having distal ends comprising the surface to be conditioned.

9. The bonding apparatus of any preceding clause, comprising: an actuatable stage configured to move the surface to be conditioned relative to the surface conditioner so as to control which part of the surface is conditioned.

10. The bonding apparatus of any preceding clause, comprising: a controller configured to control the bonding apparatus so as to condition the surface with the surface conditioner.

11. The bonding apparatus of clause 10, wherein the controller is configured to control the bonding apparatus so as to condition the surface with the surface conditioner based on a predetermined schedule.

12. The bonding apparatus of clause 10 or 11, wherein the controller is configured to control the bonding apparatus so as to condition the surface with the surface conditioner based on a measurement signal indicative of a deteriorated condition of the surface.

13. The bonding apparatus of clause 12, comprising: a deterioration sensor configured to output the measurement signal indicative of the deteriorated condition of the surface.

14. The bonding apparatus of any of clauses 10-13, wherein the controller is configured to control a force with which the surface and the at least one conditioning tool are pressed against each other.

15. The bonding apparatus of any of clauses 10-14, wherein the controller is configured to control a speed of relative movement between the surface and the at least one conditioning tool.

16. The bonding apparatus of clause 15, wherein the speed is a rotational speed.

17. A method for bonding a first substrate to a second substrate, the method comprising: supporting a first substrate with a first support; supporting a second substrate with a second support, wherein at least one of the first support and the second support comprises a surface to be conditioned, the surface configured to support the substrate; and contacting the surface to be conditioned with a surface conditioner so as to condition the surface.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1. A bonding apparatus for bonding a first substrate to a second substrate, the bonding apparatus comprising:

   a first support configured to support the first substrate;
   a second support configured to support the second substrate, wherein at least one of the first support and the second support comprises a surface to be conditioned, the surface configured to support the substrate; and
   a surface conditioner comprising at least one conditioning tool configured to contact the surface to be conditioned so as to condition the surface.

2. The bonding apparatus of claim 1, wherein the at least one conditioning tool comprises:
   a cleaning tool configured to remove contaminant matter from the surface.

3. The bonding apparatus of claim 1 or 2, wherein the at least one conditioning tool comprises:
   a roughening tool configured to roughen the surface.

4. The bonding apparatus of any preceding claim, wherein the at least one conditioning tool comprises a flattening tool configured to flatten the surface.

5. The bonding apparatus of any preceding claim, wherein each conditioning tool is selectively retractable.

6. The bonding apparatus of any preceding claim, wherein the surface conditioner comprises:
   a tool actuator configured to actuate the at least one conditioning tool to move parallel to the surface so as to condition the surface.

7. The bonding apparatus of claim 6, wherein the tool actuator is configured to rotate the at least one conditioning tool.

8. The bonding apparatus of any preceding claim, wherein at least one of the first support and the second support comprises a plurality of burls having distal ends comprising the surface to be conditioned.

9. The bonding apparatus of any preceding claim, comprising:
   an actuatable stage configured to move the surface to be conditioned relative to the surface conditioner so as to control which part of the surface is conditioned.

10. The bonding apparatus of any preceding claim, comprising a controller configured to control the bonding apparatus so as to condition the surface with the surface conditioner.

11. The bonding apparatus of claim 10, wherein the controller is configured to control the bonding apparatus so as to condition the surface with the surface conditioner based on a predetermined schedule.

12. The bonding apparatus of claim 10 or 11, wherein the controller is configured to control the bonding apparatus so as to condition the surface with the surface conditioner based on a measurement signal indicative of a deteriorated condition of the surface.

13. The bonding apparatus of claim 12, comprising a deterioration sensor configured to output the measurement signal indicative of the deteriorated condition of the surface.

14. The bonding apparatus of any of claims 10-13, wherein the controller is configured to control a force with which the surface and the at least one conditioning tool are pressed against each other.

15. A method for bonding a first substrate to a second substrate, the method comprising:

    supporting a first substrate with a first support;
    supporting a second substrate with a second support, wherein at least one of the first support and the second support comprises a surface to be conditioned, the surface configured to support the substrate; and
    contacting the surface to be conditioned with a surface conditioner so as to condition the surface.

# Fig. 1

# Fig. 2

# Fig. 3

# Fig. 4

400'

Fig. 5

# Fig. 6

# Fig. 7

# Fig. 8

Europäisches
Patentamt
European
Patent Office
Office européen
des brevets

# EUROPEAN SEARCH REPORT

**Application Number**

EP 24 21 2120

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2006 080154 A (SHIBAURA MECHATRONICS CORP) 23 March 2006 (2006-03-23) * paragraphs [0005], [0015], [0019] - [0021], [0034], [0035], [0042] - [0055] * * figures 1, 3, 4 * | 1-15 | INV. H01L21/67 |
| X | JP H06 140468 A (TOSHIBA CORP) 20 May 1994 (1994-05-20) * paragraph [0013] - paragraph [0023] * * figures 1-3 * | 1-15 | |
| A | US 9 665 013 B2 (MAPPER LITHOGRAPHY IP BV [NL]) 30 May 2017 (2017-05-30) * column 8, line 21 - line 27 * * figure 7 * * claim 1 * | 8 | |

TECHNICAL FIELDS
SEARCHED     (IPC)

H01L

The present search report has been drawn up for all claims

| Place of search | Date of completion of the search | Examiner |
|---|---|---|
| Munich | 5 November 2025 | Bruckmayer, Manfred |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 4 742 301 A1**

## ANNEX TO THE EUROPEAN SEARCH REPORT
## ON EUROPEAN PATENT APPLICATION NO.

EP 24 21 2120

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-2025

| Patent document cited in search report | | Publication date | Patent family member(s) | | Publication date |
|---|---|---|---|---|---|
| JP 2006080154 | A | 23-03-2006 | JP | 4364755 B2 | 18-11-2009 |
| | | | JP | 2006080154 A | 23-03-2006 |
| JP H06140468 | A | 20-05-1994 | NONE | | |
| US 9665013 | B2 | 30-05-2017 | US | 2009027649 A1 | 29-01-2009 |
| | | | US | 2014176920 A1 | 26-06-2014 |
| | | | US | 2014185028 A1 | 03-07-2014 |

EPO FORM P0459

For more details about this annex : see Official Journal of the European Patent Office, No. 12/82

24

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Handbook of Wafer Bonding. Wiley-VCH, 11 January 2012

- Handbook of Thin Film Deposition Processes and Techniques. Noyes Publications, 2002